Europäisches Patentamt

European Patent Office

Office européen des brevets

(11) Veröffentlichungsnummer: **0 172 525**
**A2**

(12) # EUROPÄISCHE PATENTANMELDUNG

(21) Anmeldenummer: 85110174.1

(22) Anmeldetag: 14.08.85

(51) Int. Cl.⁴: **G 03 F 1/00**
**G 03 F 7/02**

(30) Priorität: 21.08.84 DE 3430712

(43) Veröffentlichungstag der Anmeldung:
26.02.86 Patentblatt 86/9

(84) Benannte Vertragsstaaten:
DE FR GB NL

(71) Anmelder: HOECHST AKTIENGESELLSCHAFT
Postfach 80 03 20
D-6230 Frankfurt am Main 80(DE)

(72) Erfinder: Frass, Werner, Dr. Dipl.-Chem.
Erbsenacker 37
D-6200 Wiesbaden-Naurod(DE)

(72) Erfinder: Pliefke, Engelbert, Dr. Dipl.-Chem.
Fritz-Kalle-Strasse 34
D-6200 Wiesbaden(DE)

(54) Verfahren zur Reduzierung von Unterstrahlungen bei der Bestrahlung von Reproduktionsschichten.

(57) In dem Verfahren zur Reduzierung von Unterstrahlungen bei der bildmäßigen Bestrahlung der Reproduktionsschicht (en) einer Druckplatte durch eine flächige Bildvorlage wird zwischen dem flächigen Druckplattenträgermaterial und der Bildvorlage mindestens ein Gleithilfsmittel angeordnet, das sich entweder in der Reproduktionsschicht oder zwischen der Reproduktionsschicht und der Bildvorlage befindet. Als Gleithilfsmittel werden bevorzugt organische Polysiloxane, Kohlenwasserstoffpolymere, Polyarylester, Alkan- oder Alkensäuren ab $C_9$ eingesetzt. Ausgenommen sind als Gleithilfsmittel Mischpolymere aus Dimethyldichlorsilan, Ethylen- und Propylenoxid, die innerhalb der Reproduktionsschicht (en) angeordnet sind.

HOECHST AKTIENGESELLSCHAFT
KALLE Niederlassung der Hoechst AG

84/K066                        - 1 -              12. August 1985
                                                  WLK-Dr.N.-ur

Verfahren zur Reduzierung von Unterstrahlungen bei der
Bestrahlung von Reproduktionsschichten

Die Erfindung betrifft ein Verfahren zur Reduzierung von
Unterstrahlungen bei der Bestrahlung von Reproduktionsschichten durch Zugabe eines Hilfsmittels zur Reproduktionsschicht.

Trägermaterialien für Offsetdruckplatten werden entweder
vom Verbraucher direkt oder vom Hersteller vorbeschichteter Druckplatten ein- oder beidseitig mit einer strahlungsempfindlichen Schicht (Reprodukionsschicht) versehen, mit deren Hilfe ein druckendes Bild einer Vorlage
auf photomechanischem Wege erzeugt wird. Nach Herstellung
dieser Druckform aus der Druckplatte trägt der Schichtträger die beim späteren Drucken farbführenden Bildstellen und bildet zugleich an den beim späteren Drucken bildfreien Stellen (Nichtbildstellen) den hydrophilen Bilduntergrund für den lithographischen Druckvorgang.

Als Basismaterial für derartige Schichtträger können
grundsätzlich Aluminium-, Stahl-, Kupfer-, Messing- oder
Zink-, aber auch Kunststoff-Folien oder Papier verwendet
werden. Diese Rohmaterialien werden durch geeignete Modifizierungen wie z. B. Körnung, Mattverchromung, oberflächliche Oxidation und/oder Aufbringen einer Zwischenschicht in Schichtträger für Offsetdruckplatten überführt. Aluminium, das heute wohl am häufigsten verwendete Basismaterial für Offsetdruckplatten, wird nach be-

HOECHST AKTIENGESELLSCHAFT
KALLE  Niederlassung der Hoechst AG

- 2 -

kannten Methoden durch Trockenbürstung, Naßbürstung, Sandstrahlen, chemische und/oder elektrochemische Behandlung oberflächlich aufgerauht. Zur Steigerung der Abriebfestigkeit kann das aufgerauhte Substrat noch einem Anodisierungsschritt zum Aufbau einer dünnen Oxidschicht unterworfen werden.

An den strahlungsempfindlich beschichteten Druckplattenträger werden noch zusätzliche Anforderungen gestellt, die teilweise mit den Anforderungen an das Trägermaterial selbst in Wechselwirkung stehen. Dazu zählen beispielsweise eine hohe Strahlungs(Licht)empfindlichkeit, gute Entwickelbarkeit, deutliche Kontraste nach dem Belichten und/oder Entwickeln, hohe Druckauflagen und eine möglichst vorlagengetreue Reproduktion; in zunehmendem Maße spielt, insbesondere bei Druckplatten mit positiv-arbeitenden strahlungsempfindlichen Schichten, auch ein möglichst unterstrahlungsfreies Verhalten der strahlungsempfindlichen Schicht beim Bestrahlen (Belichten) der Druckplatte eine wichtige Rolle. Aus dem Stand der Technik sind beispielsweise folgende Druckschriften bekannt, die Lösungsbeiträge für diese letztgenannte Anforderung liefern:

In der  DE-A 25 12 043  (= US-A 4 168 979)  wird eine strahlungsempfindliche Druckplatte beschrieben, die auf der Oberfläche der strahlungsempfindlichen Schicht eine matte Beschichtung aufweist, die bei der Entwicklung entfernt wird. Diese matte Schicht ist im allgemeinen eine Bindemittelschicht (z. B. aus einem Celluloseether) mit darin eindispergierten, mattierenden Teilchen wie solchen aus $SiO_2$, ZnO, $TiO_2$, $ZrO_2$, Glas, $Al_2O_3$, Stärke oder Polymeren. Eine derart aufgebaute Druckplatte soll eine Verkürzung der Zeitdauer bewirken, die für das Erreichen eines möglichst umfassenden und gleichmäßigen Kontakts zwischen der Filmvorlage und der strahlungsempfindlichen Schicht während der Belichtungsstufe des Druckformherstellungsprozesses erforderlich ist.

Aus der DE-A 29 26 236 (= CA-A 1 148 014) ist ein strahlungsempfindliches Reproduktionsmaterial bekannt, das in der positiv-arbeitenden strahlungsempfindlichen Schicht Teilchen enthält, deren kleinste Abmessung mindestens so groß wie die Dicke der Schicht selbst ist, wobei die Art der Teilchen den in der vorher beschriebenen DE-A qualitativ entspricht. Ein solches Material soll für alle Anwendungen geeignet sein, bei denen positive Kontaktkopien in einem Vakuumkopierrahmen erstellt werden müssen und bei denen es auf hohe Bildauflösung und getreue Wiedergabe der Vorlage ankommt; insbesondere soll es beim Kopieren eine geringere Neigung zu Unterstrahlungen zeigen, d. h. infolge eines örtlich vergrößerten Abstands können zwischen Vorlage und strahlungsempfindlicher Schicht beim Bestrahlen Unterstrahlungen (seitlicher und schräger Strahlungseinfall) auftreten, die dann zur ungenauen Abbildung von kleinen Bildelementen wie Rasterpunkten führen.

Das Aufbringen bzw. Einbringen von Teilchen mit einem Bindemittel auf oder ohne spezielles Bindemittel in die

HOECHST AKTIENGESELLSCHAFT
KALLE Niederlassung der Hoechst AG

- 4 -

strahlungsempfindliche Schicht ist aber ein aufwendiger und viel Sorgfalt erfordernder Verfahrensschritt, insbesondere in modernen, kontinuierlich verlaufenden Beschichtungsanlagen. Außerdem stellen die aufgebrachten oder zugesetzten Teilchen beim Entwickeln der Schicht für die Entwicklungsflüssigkeit und insbesondere auch die automatisch arbeitenden Entwicklungsvorrichtungen eine Art "Fremdkörper" dar, der beim Funktionsablauf Störungen hervorrufen kann.

Aus der EP-A 0 042 104 (= US-A 4 510 227) ist - ausgehend von der Aufgabenstellung, eine gleichmäßigere Beschichtung zu erreichen - der Zusatz von oberflächenaktiven Polysiloxanen zu Reproduktionsschichten bekannt. Die eingesetzten Polysiloxane weisen sowohl Dialkylsiloxan- als auch Alkylenoxideinheiten auf. Eine Wirkung solcher Zusätze auf das Unterstrahlungsverhalten der Reproduktionsschichten wird zwar erwähnt (S. 12, Zeile 10), aber nicht näher präzisiert.

Aufgabe der vorliegenden Erfindung ist es, ein Verfahren zur Reduzierung von Unterstrahlungen bei der Bestrahlung von Reproduktionsschichten aufzuzeigen, das möglichst wenig zusätzliche Verfahrensschritte erfordert und auch bei der Weiterverarbeitung der bestrahlten Reproduktionsschicht möglichst keine negativen Folgen zeigt.

Die Erfindung geht aus von dem bekannten Verfahren zur Reduzierung von Unterstrahlungen bei der bildmäßigen Bestrahlung der Reproduktionsschicht(en) einer Druckplatte

- 5 -

durch eine flächige Bildvorlage, wobei zwischen dem flächigen Druckplattenträgermaterial und der Bildvorlage ein Hilfsmittel angeordnet wird. Das erfindungsgemäße Verfahren ist dann dadurch gekennzeichnet, daß als Hilfsmittel mindestens ein Gleithilfsmittel eingesetzt wird, wobei Mischpolymere aus Dimethyldichlorsilan, Ethylen- und Propylenoxid, die innerhalb der Reproduktionsschicht(en) angeordnet sind, ausgenommen sind.

Unter einem Gleithilfsmittel sind dabei übliche Lackzusätze zu verstehen, welche bekanntermaßen die Gleiteigenschaften von Lacken oder lackähnlichen Systemen verbessern. Dazu zählen im erfindungsgemäßen Verfahren insbesondere polymere organische Verbindungen, wie organische Polysiloxane, die als Siliconöl oder als Gemisch aus Siliconöl und Siliconharz oder -kautschuk vorliegen, bevorzugt wird dabei ein Homopolymeres aus Dimethylsiloxan-Einheiten oder ein Copolymeres aus Alkylenoxid (Ethylen- und/oder Propylenoxid)-Einheiten und Dimethylsiloxan-Einheiten eingesetzt, aber auch polysiloxanhaltige oder -freie Kohlenwasserstoffpolymere oder Polyarylester zählen zu den geeigneten polymeren organischen Verbindungen. Anstelle der oder zusätzlich zu den polymeren organischen Verbindungen können im erfindungsgemäßen Verfahren auch Alkansäuren oder Alkensäuren ab $C_9$, die gesättigt oder ungesättigt sein können, Verwendung finden; Beispiele sind Undecansäure, Octadec-9-ensäure (Ölsäure) und Octadecansäure (Stearinsäure). Die Gleithilfsmittel können einzeln oder im Gemisch eingesetzt werden; ihnen ist gemeinsam, daß sie eine öl- oder wachsartige Konsistenz haben. Ausgenommen sind von den angegebenen Verbindungen die Mischpolymeren aus Dimethyldichlorsilan, Ethylen- und Propylenoxid, die in den Beispielen 2 und 4 der eingangs bereits erwähnten EP-A 0 042 104 in der Reproduktionsschicht eingesetzt wurden und dort zu einer allerdings nicht quantifizierten Verringerung der Unterstrahlungsneigung führen sollen.

Zu den für das erfindungsgemäße Verfahren geeigneten Handelsprodukten, die insbesondere als Gleithilfsmittel auf dem Lackgebiet angeboten werden, zählen beispielsweise die Siliconöle oder siliconölhaltigen Produkte [R]Additol XL 122 [Hoechst AG - Frankfurt-Höchst (DE)], [R]Nopco LA 157, [R]Nopco LA 114, [R]Nopco LA 111 [Diamond Shamrock (USA)], Siliconöle AR 200 oder AL [Wacker-Chemie GmbH, München (DE), [R]Baysilon A [Bayer AG, Leverkusen (DE)] und [R]Tegopren 100 [Th. Goldschmidt AG, Essen (DE)] und die siliconölfreien Polymeren [R]Forbest 62 b und [R]Forbest 150 [Vertrieb: Lucas Meyer, Hamburg (DE)].

Es wird angenommen, daß im erfindungsgemäßen Verfahren die zu beobachtende Verringerung der Unterstrahlungsneigung durch eine Verminderung der Haftreibung zwischen flächiger Bildvorlage (Filmvorlage) und Reproduktionsschicht bewirkt wird. Dies steht im Gegensatz zu den Verfahren des Standes der Technik, denen eine Erhöhung der Kontaktrauhigkeit zwischen Bildvorlage und Reproduktionsschicht gemeinsam ist.

HOECHST AKTIENGESELLSCHAFT
KALLE   Niederlassung der Hoechst AG

- 7 -

Das erfindungsgemäße Verfahren kann insbesondere in den
folgenden Varianten angewendet werden:

A: Mindestens ein Gleithilfsmittel wird bereits bei der
Herstellung der Reproduktionsschicht der Beschichtungslösung zugesetzt.

B: Mindestens ein Gleithilfsmittel wird bevorzugt in verdünnter Lösung oder Dispersion vor dem Bestrahlen auf
die Reproduktionsschicht aufgebracht, und das Löse-
oder Dispergiermittel wird anschließend entfernt.

C: Mindestens ein Gleithilfsmittel wird bevorzugt in verdünnter Lösung oder Dispersion vor dem Bestrahlen auf
die Seite der flächigen Bildvorlage aufgebracht, die
mit der Reproduktionsschicht kontaktiert werden soll,
und das Löse- oder Dispergiermittel wird danach entfernt.

Bei Einsatz der Variante A ist darauf zu achten, daß der
Zusatz des Gleithilfsmittels keine Nachteile bei der
späteren Verarbeitung (Entwickeln, Gummieren, Drucken)
der Druckplatte bzw. Druckform ergibt. Eine bei Einsatz
von siliconölhaltigen Produkten gelegentlich auftretende
Erschwerung der Entwicklung durch Verringerung der Benetzung der Reproduktionsschicht mit dem meist wäßrigen
Entwickler kann durch Zusatz von Alkansäuren oder überhaupt durch Einsatz siliconölfreier Produkte ausgeglichen werden. Durch den Einsatz von Kombinationen an
Gleithilfsmitteln kann das Unterstrahlungsverhalten noch

HOECHST AKTIENGESELLSCHAFT
KALLE Niederlassung der Hoechst AG

- 8 -

weiter verbessert werden. Die Konzentration des oder der Gleithilfsmittel(s) liegt zweckmäßig in der aufgebrachten und getrockneten Reproduktionsschicht bei 0,05 bis 5 %, insbesondere bei 0,1 bis 3 %.

Bei Einsatz der Varianten B und C ist darauf zu achten, daß das Gleithilfsmittel homogen und insbesondere bei Auftrag in Lösung oder Dispersion schlierenfrei auf die jeweilige Oberfläche aufgetragen wird, da sonst eine negative Beeinflussung während der Bestrahlung auftreten kann. Die Konzentration des oder der Gleithilfsmittel(s) in Lösung oder Dispersion liegt zweckmäßig bei 0,05 bis 10 %, insbesondere bei 0,08 bis 8 % und bezogen auf das Gewicht der Reproduktionsschicht bzw. das Gewicht der Bildvorlage liegt der Anteil des oder der Gleithilfsmittel(s) nach Entfernen des Löse- oder Dispergiermittels im allgemeinen im Bereich von 0,001 bis 1 %, es sind aber auch Abweichungen davon, insbesondere nach oben, möglich. Als Löse- oder Dispergiermittel sind insbesondere niedrigsiedende Kohlenwasserstoffe wie Benzinfraktionen (in der Regel Pentane bis Decane) geeignet; möglich sind auch Glykolderivate wie Ethylenglykolmonoether, Dimethylformamid oder chlorierte Kohlenwasserstoffe wie Dichlorethan und - gegebenenfalls im Gemisch mit einigen der vorgenannten Verbindungen - Ketone wie Butanon, Glykoletherester oder cyclische Ether wie Tetrahydrofuran, bei denen aber auch ein Anquellen oder Anlösen der Reproduktionsschicht auftreten kann.

- 9 -

Die Reproduktionsschichten liegen bei den Druckplatten
als Beschichtung auf mindestens einer Oberfläche eines
Trägermaterials vor.

Zu den geeigneten Grundmaterialien für das Trägermaterial
zählen - neben den eingangs bereits erwähnten Materialien - insbesondere solche aus Aluminium oder einer seiner Legierungen, die beispielsweise einen Gehalt von mehr
als 98,5 Gew.-% an Al und Anteile an Si, Fe, Ti, Cu und
Zn aufweisen. Für die Herstellung von Druckplattenträgermaterialien wird das flächige Aluminium, gegebenenfalls
nach einer Vorreinigung, zuerst mechanisch (z. B. durch
Bürsten und/oder mit Schleifmittel-Behandlung), chemisch
(z. B. durch Ätzmittel) und/oder elektrochemisch (z. B.
durch Wechselstrombehandlung in wäßrigen Säure- oder
Salzlösungen) aufgerauht. Bevorzugt wird die elektrochemische Aufrauhung in wäßrigen Lösungen auf der Basis von
HCl und/oder $HNO_3$ durchgeführt, diese Aluminiumträgermaterialien können aber auch noch vor der elektrochemischen
Stufe mechanisch (z. B. durch Bürsten mit Draht- oder
Nylonbürsten und/oder mit Schleifmittel-Behandlung) aufgerauht werden. Alle Verfahrensstufen können diskontinuierlich mit Platten oder Folien durchgeführt werden, sie
werden aber bevorzugt kontinuierlich mit Bändern durchgeführt.

Die Vorreinigung der bevorzugt eingesetzten Aluminiummaterialien umfaßt beispielsweise die Behandlung mit
wäßriger NaOH-Lösung mit oder ohne Entfettungsmittel und/
oder Komplexbildnern, Trichlorethylen, Aceton, Methanol oder anderen handelsüblichen sogenannten Aluminiumbeizen. Der Aufrauhung oder bei mehreren Aufrauhstufen auch noch zwischen den einzelnen Stufen kann noch zusätzlich eine abtragende Behandlung nachgeschaltet werden, wobei insbesondere maximal 2 $g/m^2$ abgetragen werden (zwischen den Stufen auch bis zu 5 $g/m^2$); als abtragend wirkende Lösungen werden im allgemeinen wäßrige Alkalihydroxidlösungen bzw. wäßrige Lösungen von alkalisch reagierenden Salzen oder wäßrige Säurelösungen auf der Basis von $HNO_3$, $H_2SO_4$ oder $H_3PO_4$ eingesetzt. Neben einer abtragenden Behandlungsstufe zwischen der Aufrauhstufe und einer nachfolgenden Anodisierstufe sind auch solche nicht-elektrochemischen Behandlungen bekannt, die im wesentlichen lediglich eine spülende und/oder reinigende Wirkung haben und beispielsweise zur Entfernung von bei der Aufrauhung gebildeten Belägen ("Schmant") oder einfach zur Entfernung von Elektrolytresten dienen; im Einsatz sind für diese Zwecke beispielsweise verdünnte wäßrige Alkalihydroxidlösungen oder Wasser.

Nach dem elektrochemischen oder einem anderen Aufrauhverfahren schließt sich in einer weiteren Verfahrensstufe in der Regel eine anodische Oxidation des Aluminiums an, um beispielsweise die Abrieb- und die Haftungseigenschaften der Oberfläche des Trägermaterials zu verbessern. Zur anodischen Oxidation können die üblichen Elektrolyte wie $H_2SO_4$, $H_3PO_4$, $H_2C_2O_4$, Amidosulfonsäure, Sulfobernsteinsäure, Sulfosalicylsäure oder deren Mischungen eingesetzt werden; insbesondere werden $H_2SO_4$ und $H_3PO_4$ allein, in Mischung und/oder in einem mehrstufigen Anodisierprozeß

HOECHST AKTIENGESELLSCHAFT
KALLE Niederlassung der Hoechst AG

- 11 -

verwendet; besonders bevorzugt wird eine wäßrige $H_2SO_4$ und $Al^{3+}$-Ionen enthaltende Lösung eingesetzt. Die Oxidschichtgewichte liegen dabei im allgemeinen insbesondere zwischen 1 und 8 $g/m^2$ (entsprechend etwa 0,3 bis 2,5 μm Schichtdicke).

Die so hergestellten Materialien werden als Träger für Offsetdruckplatten verwendet, d. h. es wird entweder beim Hersteller von vorsensibilisierten Druckplatten oder direkt vom Verbraucher eine strahlungsempfindliche Beschichtung ein- oder beidseitig auf das Trägermaterial aufgebracht. Als strahlungs(licht)empfindliche Schichten sind grundsätzlich alle Schichten geeignet, die nach dem Bestrahlen (Belichten), gegebenenfalls mit einer nachfolgenden Entwicklung und/ oder Fixierung eine bildmäßige Fläche liefern, von der gedruckt werden kann. Die Bestrahlung (Belichtung) wird in der Regel in einem Kopierrahmen durchgeführt, wobei eine flächige Bildvorlage (Filmvorlage) in innigen Kontakt mit der Reproduktionsschicht unter Entlüften des Kopierrahmens (Vakuumkopierrahmen) gebracht wird.

Neben den auf vielen Gebieten verwendeten Silberhalogenide enthaltenden Schichten sind auch verschiedene andere bekannt, wie sie z. B. in "Light-Sensitive Systems" von Jaromir Kosar, John Wiley & Sons Verlag, New York 1965 beschrieben werden: die Chromate und Dichromate enthaltenden Kolloidschichten (Kosar, Kapitel 2); die ungesättigte Verbindungen enthaltenden Schichten, in denen diese Verbindungen beim Belichten isomerisiert, umgelagert, cyclisiert oder vernetzt werden (Kosar, Kapitel 4); die photopolymerisierbare Verbindungen enthaltenden Schichten, in denen Monomere oder Präpolymere gegebenenfalls mittels eines Initiators beim Belichten polymerisieren (Kosar, Kapitel 5); und die o-Diazo-chinone wie Naphthochinondiazide, p-Diazo-chinone oder Diazoniumsalz-Kondensate enthaltenden Schichten (Kosar, Kapitel 7). Zu den geeigneten Schichten zählen auch die elektrophotographischen Schichten, d. h. solche die einen anorganischen oder organischen Photoleiter enthalten. Außer den lichtempfindlichen Substanzen können diese Schichten selbstverständlich noch andere Bestandteile wie z. B. Harze, Farbstoffe oder Weichmacher enthalten. Insbesondere können die folgenden lichtempfindlichen Massen oder Verbindungen bei der Beschichtung der nach dem erfindungsgemäßen Verfahren hergestellten Trägermaterialien eingesetzt werden:

positiv-arbeitende, o-Chinondiazide, insbesondere o-Naphthochinondiazide wie Naphthochinon-(1,2)-diazid-(2)-sulfonsäureester oder -amide, die nieder- oder höhermolekular sein können, als lichtempfindliche Verbindung enthaltende Reproduktionsschichten, die beispielsweise in den DE-C 854 890, 865 109, 879 203, 894 959, 938 233, 1 109 521, 1 144 705, 1 118 606, 1 120 273, 1 124 817 und 2 331 377 und den EP-A 0 021 428 und 0 055 814 beschrieben werden;

negativ-arbeitende Reproduktionsschichten mit Kondensationsprodukten aus aromatischen Diazoniumsalzen und Verbindungen mit aktiven Carbonylgruppen, bevorzugt Kondensationsprodukte aus Diphenylamindiazoniumsalzen und Formaldehyd, die beispielsweise in den DE-C 596 731, 1 138 399, 1 138 400, 1 138 401, 1 142 871, 1 154 123, den US-A 2 679 498 und 3 050 502 und der GB-A 712 606 beschrieben werden;

negativ-arbeitende, Mischkondensationsprodukte aromatischer Diazoniumverbindungen enthaltende Reproduktionsschichten, beispielsweise nach der DE-C 20 65 732, die Produkte mit mindestens je einer Einheit aus a) einer kondensationsfähigen aromatischen Diazoniumsalzverbindung und b) einer kondensationsfähigen Verbindung wie einem Phenolether oder einem aromatischen Thioether, verbunden durch ein zweibindiges, von einer kondensationsfähigen Carbonylverbindung abgeleitetes Zwischenglied wie einer Methylengruppe aufweisen;

positiv-arbeitende Schichten nach der DE-A 26 10 842, der DE-C 27 18 254 oder der DE-A 29 28 636, die eine bei Bestrahlung Säure abspaltende Verbindung, eine monomere oder polymere Verbindung, die mindestens eine durch Säure abspaltbare C-O-C-Gruppe aufweist (z. B. eine Orthocarbonsäureestergruppe oder eine Carbonsäureamidacetalgruppe) und gegebenenfalls ein Bindemittel enthalten;

- 14 -

negativ-arbeitende Schichten aus photopolymerisierbaren
Monomeren, Photoinitiatoren, Bindemitteln und gegebenenfalls weiteren Zusätzen; als Monomere werden dabei beispielsweise Acryl- und Methacrylsäureester oder Umsetzungsprodukte von Diisocyanaten mit Partialestern mehrwertiger Alkohole eingesetzt, wie es beispielsweise in
den US-A 2 760 863 und 3 060 023 und den DE-A 20 64 079
und 23 61 041 beschrieben wird;

negativ-arbeitende Schichten gemäß der DE-A 30 36 077,
die als lichtempfindliche Verbindung ein Diazoniumsalz-
Polykondensationsprodukt oder eine organische Azidoverbindung und als Bindemittel ein hochmolekulares Polymeres mit seitenständigen Alkenylsulfonyl- oder Cycloalkenylsulfonylurethan-Gruppen enthalten.

Es können auch photohalbleitende Schichten, wie sie z.B.
in den DE-C 11 17 391, 15 22 497, 15 72 312, 23 22 046
und 23 22 047 beschrieben werden, auf die erfindungsgemäß
hergestellten Trägermaterialien aufgebracht werden, wodurch hoch-lichtempfindliche, elektrophotographischarbeitende Druckplatten entstehen.

Das erfindungsgemäße Verfahren kann so durchgeführt werden, daß die eingangs dargestellten Probleme bei der Herstellung und Weiterverarbeitung der Reproduktionsschichten auf Druckplatten nicht auftreten. Es führt zu einer
deutlichen Reduzierung von Unterstrahlungen.

HOECHST AKTIENGESELLSCHAFT
KALLE Niederlassung der Hoec ıst AG

- 15 -

In der vorstehenden Beschreibung und den nachfolgenden Beispielen bedeuten %-Angaben, wenn nichts anderes bemerkt wird, immer Gew.-%. Gew.-Teile stehen zu Vol.-Teilen im Verhältnis von g zu cm$^3$. Im übrigen wurden folgende Methoden zur Parameterbestimmung in den Beispielen angewandt:

Die Belichtungszeit bezeichnet die jeweils bis zur Wegbelichtung von Schnittkanten aufzuwendende Zeitspanne. Bei der Bestimmung des "Rutschwinkels" werden die Druckplatte bzw. die Bildvorlage stufenweise so angehoben, daß eine schiefe Ebene entsteht, auf der ein Prüfgewicht auf der Reproduktionsschicht bzw. der behandelten Oberfläche heruntergleiten kann, wenn der Winkel gegen die Horizontale genügend groß ist. Es wird in der Tabelle der Winkel angegeben, der mindestens erforderlich ist, um das in Bewegung gesetzte Prüfgewicht ohne Abbremsung die Prüfstrecke durchlaufen zu lassen. Die Unterstrahlungsneigung wird visuell beurteilt und von sehr stark (--) über -, 0-, 0, 0+, + bis sehr gering (++) klassifiziert.

Als strahlungsempfindliche Schicht wird entweder eine negativ-arbeitende (Beispiel 25 und Vergleichsbeispiel V4) mit einem Gehalt an einem Umsetzungsprodukt von Polyvinylbutyral mit Propenylsulfonylisocyanat, 2,6-Bis-(4-azidobenzol)-4-methyl-cyclohexanon, [R]Rhodamin 6 GDN extra und 2 Benzoylmethylen-1-methyl-β-naphthothiazolin in Ethylenglykolmonomethylether und Tetrahydrofuran (Feststoffgehalt etwa 29,5 Gew.-Teile auf 150 Vol.-Teile Lösemittel) oder eine positiv-arbeitende (Beispiele 1 bis 24 und Vergleichsbeispiele V1 bis V3) mit einem Gehalt an einem Kresol-Formaldehyd-Novolak; Naphthochinondiazidsulfonsäureester hergestellt aus Naphthochinon-(1,2)-diazid(2)-sulfonsäurechlorid-(5), Kresol-Formaldehyd-Novolak und 2,3,4-Trihydroxybenzophenon in Gegenwart einer Base; Naphthochinon(1,2)-diazid-(2)-sulfonsäurechlorid-(4) und Kristallviolett in Tetrahydrofuran, Ethylenglykolmonomethylether und Essigsäurebutylester (Feststoffgehalt etwa 2,2 Gew.-Teile auf 90 Vol.-Teile Lösemittel) auf das Trägermaterial aufgebracht. Es lassen sich so praxisgerechte Druckplatten und Druckformen daraus erstellen.

Es kommen in den Beispielen folgende Gleithilfsmittel (GH) zum Einsatz:

GH  1: Ölsäure
GH  2: Siliconöl mit einem Gehalt an Siliconkautschuk
       ([R]Additol XL 122)
GH  3: siliconöl- und mineralölfreies Kohlenwasserstoffpolymeres ([R]Forbest 62 b)
GH  4: Copolymeres aus Ethylenglykol und Dimethylsiloxan
       ([R]Nopco LA 157)
GH  5: harz- und siliconfreier Polyarylester
       ([R]Forbest 150)
GH  6: Siliconöl ("AR 200")
GH  7: Siliconöl ([R]Nopco LA 114)
GH  8: Stearinsäure
GH  9: Chlorparaffin
GH 10: Polydimethylsiloxan ([R]Baysilon A)

HOECHST AKTIENG SELLSCHAFT
KALLE Niederlassung der Hoechst AG

- 17 -

GH 11: Terpolymeres aus Ethylen-, Propylenglykol und Dimethylsiloxan ($^{(R)}$Tegopren 100)

GH 12: Siliconöl ("AL")

GH 13: Undecansäure

GH 14: Copolymeres aus Ethylenglykol und Dimethylsiloxan ($^{(R)}$Nopco LA 111)

Beispiele 1 bis 12 und Vergleichsbeispiel V1

Der vorstehend angegebenen positiv-arbeitenden Beschichtung werden die in der Tabelle I angegebenen Gleithilfsmittel zugegeben, die angegebenen Konzentrationen beziehen sich auf den Feststoffanteil der Reproduktionsschicht.

Beispiele 13 bis 18 und Vergleichsbeispiel V2

Auf eine gleithilfsmittelfreie positiv-arbeitende Reproduktionsschicht wird das Gleithilfsmittel in Testbenzin als Lösemittel aufgestrichen (Tabelle II).

Beispiele 19 bis 25 und Vergleichsbeispiele V3 und V4

Auf eine Vorlage (Polyethylenglykolterephthalat) wird auf die Seite, die die Filmmontage trägt, das Gleithilfsmittel in Testbenzin als Lösemittel aufgestrichen (Tabelle III). Die Reproduktionsschicht ist eine positiv-arbeitende in den Beispielen 19 bis 24 und V3 und eine negativ-arbeitende in den Beispielen 25 und V4.

HOECHST AKTIENGESELLSCHAFT
KALLE Niederlassung der Hoechst AG

Tabelle I

| Bei- spiel | Gleithilfsmittel | | Belichtungs- zeit | Rutsch- winkel | Unter- strah- lung |
| --- | --- | --- | --- | --- | --- |
| | Typ(en) | Konzentra- tion(en)(%) | (sec) | (°) | |
| V 1 | - | - | 100 | 30 | -- |
| 1 | GH 1 | 1,00 | 90 | 24 | 0 |
| 2 | GH 2 | 0,75 | 130 | 16 | + |
| 3 | GH 2 GH 1 | 0,75 0,50 | 100 | 14 | ++ |
| 4 | GH 3 | 1,00 | 160 | 15 | ++ |
| 5 | GH 4 | 1,00 | 130 | 10 | ++ |
| 6 | GH 4 GH 1 | 1,00 1,00 | 120 | 6 | ++ |
| 7 | GH 2 | 0,25 | 110 | 26 | 0 |
| 8 | GH 2 | 1,00 | 150 | 10 | ++ |
| 9 | GH 5 | 1,00 | 140 | 13 | ++ |
| 10 | GH 5 GH 1 | 1,00 1,00 | 100 | 9 | ++ |
| 11 | GH 2 GH 1 | 0,25 0,75 | 100 | 17 | ++ |
| 12 | GH 2 GH 8 | 0,25 0,75 | 110 | 20 | + |

Tabelle II

| Bei-spiel | Gleithilfsmittel | | Belichtungs-zeit | Rutsch-winkel | Unter-strah-lung |
|---|---|---|---|---|---|
| | Typ(en) | Konzentra-tion(en)(%)*) | (sec) | (°) | |
| V 2 | - | - | 100 | 28 | -- |
| 13 | GH 2 | 1,00 | 120 | 9 | + |
| 14 | GH 2 | 5,00 | 130 | 6 | ++ |
| 15 | GH 6 | 1,00 | 130 | 12 | 0+ |
| 16 | GH 2 GH 9 | 2,50 2,50 | 100 | 12 | ++ |
| 17 | GH 2 GH 1 | 3,75 1,25 | 100 | 10 | ++ |
| 18 | GH 7 | 1,00 | 110 | 14 | + |

Tabelle III

| Bei-spiel | Gleithilfsmittel | | Belichtungs-zeit | Rutsch-winkel | Unter-strah-lung |
|---|---|---|---|---|---|
| | Typ(en) | Konzentra-tion(en)(%)*) | (sec) | (°) | |
| V 3 | - | - | 100 | 23 | -- |
| 19 | GH 10 | 0,1 | 100 | 10 | + |
| 20 | GH 11 | 1,0 | 100 | 11 | 0+ |
| 21 | GH 12 | 0,1 | 100 | 11 | ++ |
| 22 | GH 13 | 0,1 | 100 | 11 | ++ |
| 23 | GH 2 | 1,0 | 100 | 11 | + |
| 24 | GH 14 | 1,0 | 100 | 12 | + |
| V 4 | - | - | 40 | 23 | - |
| 25 | GH 14 | 1,0 | 40 | 12 | + |

*) bezogen auf die aufgestrichene Lösung bzw. Dispersion

Patentansprüche

1. Verfahren zur Reduzierung von Unterstrahlungen bei der bildmäßigen Bestrahlung der Reproduktionsschicht(en) einer Druckplatte durch eine flächige Bildvorlage, wobei zwischen dem flächigen Druckplattenträgermaterial und der Bildvorlage ein Hilfsmittel angeordnet wird, dadurch gekennzeichnet, daß als Hilfsmittel mindestens ein Gleithilfsmittel eingesetzt wird, wobei Mischpolymere aus Dimethyldichlorsilan, Ethylen- und Propylenoxid, die innerhalb der Reproduktionsschicht(en) angeordnet sind, ausgenommen sind.

2. Verfahren nach Anspruch 1, dadurch gekennzeichnet, daß das Gleithilfsmittel ein organisches Polysiloxan, ein Kohlenwasserstoffpolymeres, ein Polyarylester, eine Alkansäure oder eine Alkensäure ab $C_9$ ist.

3. Verfahren nach Anspruch 1 oder 2, dadurch gekennzeichnet, daß das Gleithilfsmittel in der Reproduktionsschicht und der Bildvorlage eingesetzt wird.

4. Verfahren nach Anspruch 3, dadurch gekennzeichnet, daß 0,05 bis 5 Gew.-%, bezogen auf die Summe der Komponenten der Reproduktionsschicht, des Gleithilfsmittels eingesetzt werden.

5. Verfahren nach Anspruch 1 oder 2, dadurch gekennzeichnet, daß das Gleithilfsmittel zwischen der Reproduktionsschicht und der Bildvorlage eingesetzt wird.

HOECHST AKTIENGESELLSCHAFT
KALLE Niederlassung der Hoechst AG

- 21 -

6. Verfahren nach Anspruch 5, dadurch gekennzeichnet, daß das Gleithilfsmittel auf die Reproduktionsschicht aufgebracht wird.

7. Verfahren nach Anspruch 5, dadurch gekennzeichnet, daß das Gleithilfsmittel auf die Bildvorlage aufgebracht wird.

8. Verfahren nach Anspruch 5, dadurch gekennzeichnet, daß 0,001 bis 1 Gew.-%, bezogen auf das Gewicht der Reproduktionsschicht bzw. Bildvorlage, des Gleithilfsmittels eingesetzt werden.

-.-.-